# EUROPÄISCHE PATENTSCHRIFT

(11) **EP 1 546 434 B1**
(45) Veröffentlichungstag und Bekanntmachung des Hinweises auf die Patenterteilung: **27.07.2011**
(21) Anmeldenummer: 03798847.4
(22) Anmeldetag: 09.09.2003
(51) Int. Cl.: C23C 16/509, H01J 37/32

(54) **VORRICHTUNG ZUR DURCHFÜHRUNG EINES PLASMA-UNTERSTÜTZTEN PROZESSES**
DEVICE FOR CARRYING OUT A PLASMA-ASSISTED PROCESS
DISPOSITIF POUR REALISER UN PROCESSUS RENFORCE AU PLASMA

(30) Priorität: 03.10.2002 CH 16532002
(43) Veröffentlichungstag der Anmeldung: 29.06.2005
(73) Patentinhaber: Tetra Laval Holdings & Finance S.A., 1009 Pully (CH)
(72) Erfinder: FAYET, Pierre, CH-1006 Lausanne (CH); JACCOUD, Bertrand, CH-1678 Siviriez (CH)
(74) Vertreter: Frei Patent Attorneys
(86) Internationale Anmeldenummer: PCT/CH2003/000610
(87) Internationale Veröffentlichungsnummer: WO 2004/031441

(56) Entgegenhaltungen:
- EP-A- 0 299 754
- US-A- 5 224 441
- FUJIMAKI S ET AL: "New DLC coating method using magnetron plasma in an unbalanced magnetic field" FIFTH INTERNATIONAL SYMPOSIUM ON SPUTTERING AND PLASMA PROCESSES (ISSP'99), KANAZAWA, JAPAN, 16-18 JUNE 1999, Bd. 59, Nr. 2-3, Seiten 657-664, XP002231851 Vacuum, Nov.-Dec. 2000, Elsevier, UK ISSN: 0042-207X
- BIEDERMAN H ET AL: "Characterization of an unbalanced magnetron for composite film (metal/C:H) deposition" VACUUM, APRIL 1999, ELSEVIER, UK, Bd. 52, Nr. 4, Seiten 415-420, XP002231852 ISSN: 0042-207X

## Beschreibung

Die Erfindung betrifft eine Vorrichtung nach dem Oberbegriff des ersten unabhängigen Patentanspruchs. Die Vorrichtung dient zur Durchführung eines Plasma-unterstützten Prozesses, insbesondere einer Plasma-unterstützten, chemischen Abscheidung aus der Gasphase (plasma enhanced chemical vapour deposition). Die Vorrichtung dient also beispielsweise zur Beschichtung der einen Seite einer Bahn eines Filmmaterials, insbesondere zur Beschichtung eines Kunststofffilmes mit Siliziumoxyd zur Verbesserung der Barriereeigenschaften des Kunststofffilms.

Es ist beispielsweise aus der Publikation EP-299754 (BOC) bekannt, eine dünne Schicht Siliziumoxyd auf einem Substrat abzuscheiden unter Verwendung einer Plasma-unterstützten, chemischen Abscheidung aus der Gasphase. Gemäss dieser Publikation wird das elektrisch isolierte Substrat derart in einer Vakuumkammer positioniert, dass es der Frontfläche eines mit einer Wechselspannung gespeisten Magnetrons zugewandt ist. Ein Prozessgas, das aus einer Organosilizium-Verbindung, Sauerstoff und einem inerten Gas (z.B. Argon oder Helium) besteht, wird in den Raum zwischen der Front des Magnetrons und dem Substrat eingeleitet und das Plasma, das aus diesem Prozessgas abgeleitet wird, wird aufrechterhalten bei einem Druck von beispielsweise 6 Pa.

Das Magnetron, das in der Publikation EP-0299754 beschrieben wird, ist ein flaches Magnetron des ausgeglichenen (balanced) oder unausgeglichenen (unbalanced) Typs. Der Grad an Unausgeglichenheit eines flachen Magnetrons ist abhängig von der Stärke des magnetischen Poles oder der magnetischen Pole, die auf jeder der beiden Seiten des auf der Front des Magentrons verlaufenden Rund-Tracks angeordnet sind, das heisst vom Verhältnis zwischen der Zahl von magnetischen Feldlinien, die über den Track von Nord- zu Südpol verlaufen und der Zahl von Feldlinien, die das nicht tun. Das unausgeglichene Magnetron kann bekannterweise nicht alle Elektronen und Ionen des Plasmas gefangen halten, derart, dass eine beschränkte Zahl von Elektronen und Ionen auf das Substrat treffen, was offenbar die Qualität der Abscheidung verbessert. Die Front des unausgeglichenen Magnetrons gemäss EP-0299754 weist periphere Nordpole und einen zentralen Kern aus Weicheisen auf, so dass nur ein kleiner Teil der Feldlinien von den Nordpolen zum Kern verlaufen (stark unausgeglichenes Magnetron).

Die Publikation EP-0605534 (BOC) beschreibt eine ähnliche, Plasma-unterstützte Abscheidung aus der Gasphase, wobei das Substrat bandförmig ist. Das bandförmige Material wird getragen von einer rotierenden Trommel, die mit elektrischer Energie versorgt wird und unter einer negativen Vorspannung steht. Ein geerdeter und gegebenenfalls gekühlter Schild ist gegen das von der Trommel getragene bandförmige Material gewandt und trägt auf seiner Rückseite mindestens ein Paar von entgegengesetzten magnetischen Polen, vorzugsweise eine Mehrzahl von alternierenden Magnetpolen. Mit Hilfe des magnetischen Feldes wird das Plasma zwischen der Trommel und dem Schild gefangen gehalten. Der Vorteil der Anordnung soll die Entkoppelung von elektrischem und magnetischem Feld sein, die offenbar zu einer Ausdehnung des Plasmas auf das ganze Volumen zwischen Trommel und Schild führt. Der Abstand zwischen Trommel und Schild wird mit einer Breite zwischen 1 und 30 cm angegeben.

Die Aufgabe der Erfindung besteht darin, die oben genannten Vorrichtungen, die zur Durchführung von Plasma-unterstützten Prozessen dienen, insbesondere zur Durchführung von Plasma-unterstützten, chemischen Abscheidungen aus der Gasphase aber auch zur Durchführung von beispielsweise Plasma-Ätzprozessen oder Prozessen zur Veränderung von Benetzbarkeit oder Adhäsion, und die auf einem Magnetron basieren. Die Verbesserung soll sich insbesondere auf die Effizienz des Prozesses beziehen. Für Abscheidungsprozesse soll also die bei einem vorgegebenen Energieverbrauch erreichbare Abscheidungsgeschwindigkeit, aber auch die Qualität der Abscheidung verbessert werden.

Diese Aufgabe wird gelöst durch die Vorrichtung, wie sie in den Patentansprüchen definiert ist.

Die Vorrichtung gemäss Erfindung weist eine Vakuumkammer auf und in der Vakuumkammer angeordnet mindestens eine Magnetron-Elektrode mit einer unausgeglichenen Anordnung von Magnetpolen sowie ein Positioniermittel, das als Gegenelektrode funktioniert und zum Positionieren eines Substrates ausgerüstet ist, dessen zu behandelnde Oberfläche gegen die Magentron-Elektrode gewandt ist. Vorteilhafterweise ist die Magnetron-Elektrode an die Wechselspannung angeschlossen und ist das Substrat oder das Positioniermittel elektrisch geerdet, ohne definiertes Referenzpotential (floating) oder an eine negative Vorspannung angeschlossen. Der Abstand zwischen der Front des Magentrons und der zu behandelnden Oberfläche wird abgestimmt an die Eigenschaften des durch die permanenten Magnetpole des Magnetrons erzeugten magnetischen Feldes, das seinerseits abhängig ist hauptsächlich von der Stärke der Pole, vom Grad der Unausgeglichenheit der Polanordnung und von der Breite des Tracks zwischen den Magnetpolen.

Experimente an einer Plasma-unterstützten Abscheidung aus der Gasphase in einem ansonsten unveränderten System (gleiches magnetisches Feld und gleiches elektrisches Feld) zeigen, dass die Abscheidungsgeschwindigkeit abhängig ist vom Abstand zwischen der Front des Magnetrons und dem Substrat derart, dass ein Optimum für die Abscheidungsgeschwindigkeit gefunden wird, wenn die zu beschichtende Oberfläche gerade ausserhalb der Tunnels angeordnet wird, die durch Feldlinien gebildet werden, die sich über den Track auf der Magnetron-Front erstrecken. Das heisst mit anderen Worten: die Abscheidungsgeschwindigkeit ist am grössten, wenn der Abstand zwischen der Front des Magnetrons und der zu beschichtenden Oberfläche nur wenig grösser ist als die Höhe der Tunnels über der Front des Magnetrons. Vorteilhafterweise ist der Abstand zwischen der zu beschichtenden Oberfläche und der Front des Magnetrons etwa 2 bis 20% grösser als die Höhe der Tunnels. In diesem Bereich, in dem die zu beschichtende Oberfläche positioniert wird, ist die Elektronendichte höher als in den Tunnels, die Feldlinien sind aber immer noch durch die Tunnels geformt, das heisst, sie weisen eine Komponente parallel zur Front des Magnetrons auf.

Bei visueller Beobachtung eines Plasmas, das zwischen einem unausgeglichenen Magnetron mit einer flachen, rechteckigen Front (Blickwinkel parallel zur längeren Seite der Front) und einer Oberfläche, die für die Behandlung im wesentlichen parallel zur Front des Magnetrons angeordnet ist, erscheinen die genannten Tunnels als gut unterscheidbare, dunklere Bereiche innerhalb des Plasmas, das ausserhalb der Tunnels heller ist. Die oben diskutierte Einstellung des Abstandes zwischen der Magnetron-Front und der zu behandelnden Oberfläche, die abhängig von den Eigenschaften des magnetischen Feldes sein soll, kann einfach auf einer solchen Beobachtung basierend erstellt werden. Die zu behandelnde Oberfläche wird ausserhalb der Tunnels positioniert, derart, dass sich ein heller Plasmastreifen zwischen den Tunnels und der zu behandelnden Oberfläche erstreckt, welcher Plasmastreifen eine minimal Breite aber gegen die zu behandelnde Oberfläche eine homogene Helligkeit aufweist, das heisst dieselbe Helligkeit an Positionen über den Tunnels und an Positionen über dem Zwischenraum zwischen den Tunnels.

Das Prinzip der erfindungsgemässen Vorrichtung und eine bevorzugte Ausführungsform davon werden ausführlich beschrieben im Zusammenhang mit den folgenden Figuren. Diese zeigen:
- Figur 1: das Prinzip der erfindungsgemässen Vorrichtung;
- Figuren 2 und 3: eine beispielhafte Magnetron-Elektrode, die in der erfindungs- gemässen Vorrichtung anwendbar ist (Figur 2: Draufsicht auf die Front des Magnetrons; Figur 3: Schnitt senkrecht zur Front, Schnittlinie III-III in Fi- gur 2);
- Figur 4: eine bevorzugte Ausführungsform der erfindungsgemässen Vorrichtung, die der Beschichtung eines bandförmigen, flexiblen_Materials dient, bei- spielsweise der Beschichtung eines Kunststofffilms mit Siliziumoxyd zur Verbesserung der Barriereeigenschaften des Filmmaterials.

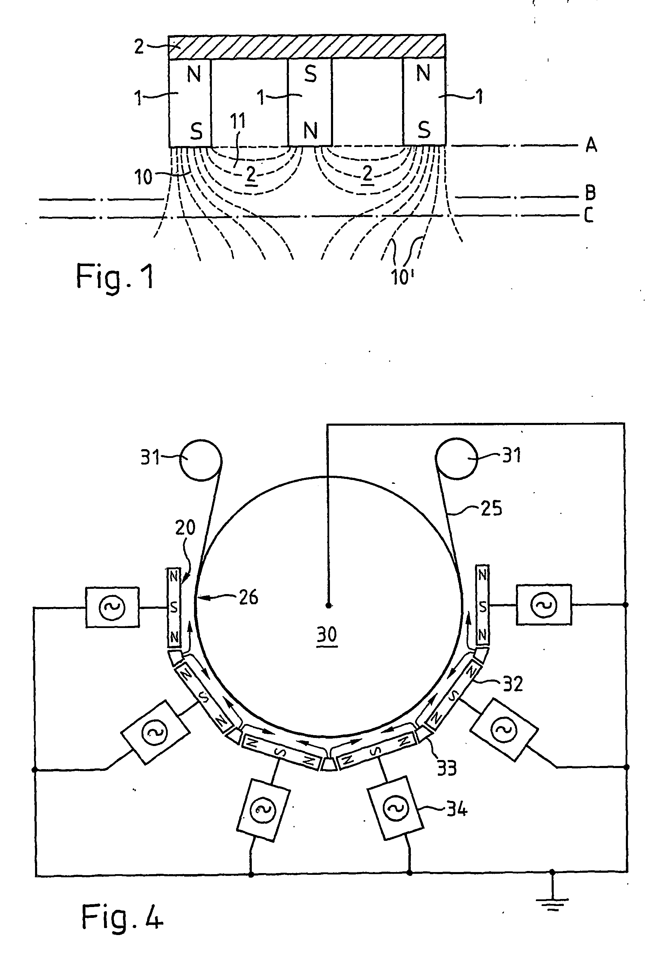

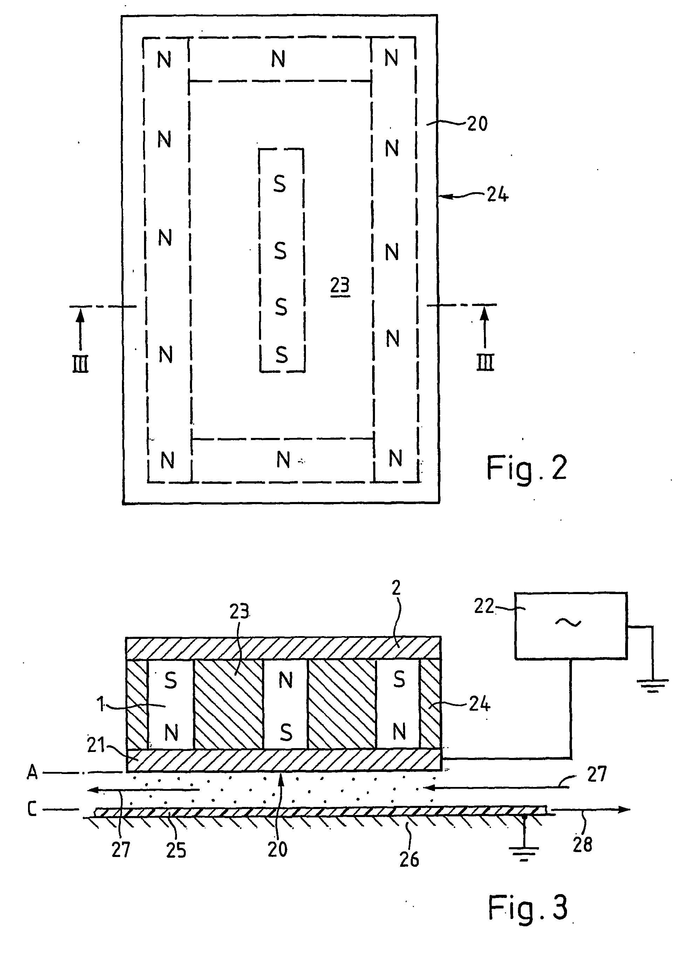

Figur 1 zeigt das magnetische Feld eines flaschen, unausgeglichenen Magnetrons in einem Schnitt senkrecht zur Magnetron-Front. Drei Permanentmagnete 1 sind alternierend angeordnet, wobei ihre Pole auf der einen Seite durch ein Verbindungsstück 2 aus einem magnetisierbaren Material (z.B. Weicheisen) verbunden sind. Die magnetischen Pole gegenüber dem Verbindungsstück 2 bilden die flache Front des Magnetrons (Ebene A), die beispielsweise einen zentralen Nordpol aufweist, der dieselbe Stärke hat wie jeder der beiden peripheren Südpole. Das Magnetron weist weiter nicht dargestellte Mittel zur Erzeugung eines alternierenden elektrischen Feldes auf, dessen Feldlinien im wesentlichen senkrecht zur Magnetron-Front verlaufen. Dieses Mittel ist beispielsweise ein Elektrodenelement, das sich über die Front des Magnetrons erstreckt und an eine Wechselspannungsquelle angeschlossen ist (siehe auch Figur 3).

Die Anordnung der magnetischen Pole der Front des unausgeglichenen Magnetrons erzeugt einen ersten Teil von magnetischen Feldlinien 10, die vom Nordpol zu einem der Südpole verlaufen und Tunnels 11 bilden, an deren Basis Elektronen und Ionen gefangen bleiben, und einen zweiten Teil von magnetischen Feldlinien 10', die anderswo herkommen und in den Südpolen enden. Die Höhe der Tunnels 11 über der Magnetron-Front (Ebene B) ist abhängig von der magnetischen Stärke der Pole, von den Abständen zwischen den Polen (Breite des Tracks) und vom Verhältnis der Stärken von zentralem Pol und peripheren Polen (Grad der Unausgeglichenheit des Magnetrons).

Erfindungsgemäss wird die zu behandelnde Oberfläche (Ebene C) derart positioniert, dass sie eindeutig ausserhalb der Tunnels 11 angeordnet ist, aber so nahe wie möglich an der Front A des Magnetrons. Der Abstand zwischen den Ebenen A und C ist vorteilhafterweise mindestens 2% grösser als der Abstand zwischen den Ebenen A und B, noch vorteilhafter zwischen 2 und 20% grösser als der Abstand zwischen den Ebenen A und B.

Figuren 2 und 3 zeigen eine beispielhafte Ausführungsform einer Magnetron-Elektrode für die erfindungsgemässe Vorrichtung. Die Magnetron-Elektrode hat eine flache, rechteckige Front und ist wiederum vom unausgeglichen Typus. Figur 2 zeigt die Front des Magnetrons. Figur 3 zeigt einen Schnitt senkrecht zur Front (Schnittlinie III-III in Figur 2) und ein Substrat, das beispielsweise für eine Beschichtung der Front des Magnetrons zugewandt angeordnet ist.

Die Magnetron-Elektrode weist alternierend angeordnete, permanente Magnete 1 auf. Eine periphere Anordnung von Nordpolen und eine zentrale Linie von Südpolen (oder fünf stabförmige Magnete, deren Pole an einander gegenüberliegenden Längsseiten liegen) bilden die Front 20 des Magnetrons, die mit einem Elektrodenelement 21 bedeckt ist. Das Elektrodenelement 21 besteht aus einem nicht magnetisierbaren Material (z.B. Aluminium, rostfreier Stahl oder Kupfer) und ist an eine Quelle 22 einer hochfrequenten Wechselspannung angeschlossen. Dasselbe, nicht magnetisierbare Material ist vorteilhafterweise auch verwendet zum Füllen der Zwischenräume 23 zwischen den Permanentmagneten 1. Die magnetischen Pole, die von der Magnetron-Front abgewandt sind, sind verbunden über ein Verbindungsstück 2 aus einem magnetisierbaren Material, z.B. Weicheisen. Eine Wandung 24, die die Permanentmagnete 1 seitlich umgibt, besteht vorteilhafterweise ebenfalls aus einem magnetisierbaren Material.

Das zu behandelnde Substrat ist beispielsweise ein bandförmiges Material 25, das von einer elektrisch geerdeten Unterlage 26 gestützt und kontinuierlich auf der Unterlage 26 bewegt wird (Pfeil 28). Die Unterlage kann auch ohne definiertes Referenzpotential sein oder an einer negativen Vorspannung anliegen. Das Plasma ist gefangen zwischen der Magnetron-Front und dem Substrat, wobei optimale Abscheidung (oder andere Behandlung) erreicht wird bei einem Abstand A-C, der die oben gegebenen Bedingungen erfüllt. Die Prozessgasmischung wird durch den Plasmabereich geleitet, beispielsweise wie durch die Pfeile 27 illustriert.

Figur 4 zeigt eine beispielhafte Ausführungsform der erfindungsgemässen Vorrichtung, die der Beschichtung oder anderen Plasma-unterstützten Behandlung eines bandförmigen, flexiblen Substratmaterials dient. Das Substratmaterial wird durch eine rotierende Trommel 30 transportiert, wobei die Trommel die Unterlage 26 für das Substrat 25 darstellt. Das Substratmaterial wird von einer ersten Speicherrolle 31 abgewickelt und auf eine zweite Speicherrolle 31 wieder aufgewickelt. Um einen Teil des Umfangs der Trommel 30 und mit dem oben beschriebenen Abstand davon ist eine Mehrzahl von Magnetron-Elektroden 32 gemäss Figuren 2 und 3 angeordnet. Die Magnetron-Fronten sind gegen die Trommel 30 gewandt und ihre Länge ist parallel zur Trommelachse ausgerichtet. Gaszuführungsleitungen 33 (z.B. Rohre mit einer Reihe von Zuführungsöffnungen) für die Zufuhr der Prozessgasmischung sind in den Zwischenräumen zwischen den Magnetron-Elektroden 32 angeordnet. Die Anordnung von Trommel 30, Speicherrollen 31, Magnetron-Elektroden 32 und Gaszuführungsleitungen 33 ist in einer nicht dargestellten Vakuumkammer untergebracht, wobei die Vakuumkammer mit Mitteln zum Abführen des Gases aus der Kammer und zur Konstanthaltung des Druckes in der Kammer ausgerüstet ist. Jede Magnetron-Elektrode 32 wird vorteilhafterweise elektrisch gespeist durch eine eigene Versorgung mit elektrischer Energie. Das Prozessgas fliesst hauptsächlich von den Zuführungsleitungen 33 gegen die Stirnseiten der Trommel, von wo es abgepumpt wird.

Experimente zeigen, dass bei Verwendung einer Anordnung mit einer Mehrzahl von individuell gespeisten Magnetron-Elektroden 32 nicht nur der Betrieb zuverlässiger wird (Betrieb kann bei Ausfall einer Elektrode weitergeführt werden mit einer entsprechend reduzierten Geschwindigkeit des Substrates) sondern auch die Effizienz des Prozesses. Während in einer Anordnung, wie sie in der Figur 4 dargestellt ist, ein sichtbar homogenes Plasma entlang der zu behandelnden Substratoberfläche und eine hohe Betriebsstabilität entsteht, produziert eine Anordnung (wie beispielsweise beschrieben in der Publikation EP-0605534) mit einem einzigen Magnetron-ähnlichen Schild, die einen gleichen Sektor der Trommel umfasst, einen Gradienten in der Plasmaintensität entlang des Zwischenraumes zwischen Trommel und Schild, derart, dass die Plasmaintensität sich vom Eingang in diesen Zwischenraum zum Ausgang vergrössert und eine sehr hohe Plasmaintensität im Ausgangsbereich eine Quelle von Unstabilitäten darstellt.

### Beispiel 1

Eine Vorrichtung gemäss Figur 4 wird eingesetzt für die Beschichtung eines Kunststofffilmes mit Siliziumoxyd unter Verwendung eines Plasmas, das aufrechterhalten wird in einer Prozessgasmischung, die eine Organo-Silizium-Verbindung und Sauerstoff enthält. Die Vorrichtung weist vier Magnetron-Elektroden gemäss Figuren 2 und 3 auf, wobei jede eine Front von 600 x 150 mm aufweist und einen zentralen Permanentmagneten einer Stärke von ca. 100 Gauss (10⁻² Tesla) und um den zentralen Magenten angeordnete, periphere Magnete von insgesamt im wesentlichen 200 Gauss und wobei der Abstand zwischen den Polen (Track-Breite) ca. 50 mm beträgt. Die Magnetron-Fronten haben einen Abstand von der Umfangsfläche der Trommel, der ca. 60 mm beträgt (sichtbar derart, dass ein schmales, helles Plasmaband sich über den Tunnels entlang dem Substrat erstreckt, wobei das Plasmaband gegen das Substrat eine regelmässige Intensität aufweist, die nicht abhängig ist von den Tunnelpositionen). Die Magnetron-Elektroden werden mit einem Total von 14 kW pro m² Magnetron-Front und einer Frequenz von 40 KHz gespeist. Die Abscheidungsgeschwindigkeit, die damit erreicht wird, beträgt ca. 3 nm per Sekunde, die Barrierequalität der Beschichtung ist hoch und der Betrieb stabil. Veränderungen des Abstandes zwischen den Magentron-Fronten und der Umfangsfläche der Trommel resultieren in beiden Richtungen in einer relevanten Reduktion der Abscheidungsgeschwindigkeit.

Bei Verwendung einer gleichen Installation und gleichen Betriebsparametern ausser der Magnetstärke, die vier mal höher gewählt wird, erreicht die Abscheidegeschwindigkeit ein Maximum bei einem Abstand zwischen den Magnetron-Fronten und der Umfangsfläche der Trommel, der grösser ist als 60 mm, nämlich zwischen etwa 80 und 100 mm, und die Abscheidegeschwindigkeit ist relevant höher als bei Verwendung der schwächeren Magnete.

## Patentansprüche

1. Vorrichtung zur Durchführung eines Plasma-unterstützten Prozesses, insbesondere einer Plasma-unterstützten, chemischen Abscheidung aus der Gasphase, welche Vorrichtung in einer Vakuumkammer eine Magnetron-Elektrode (32), ein Positioniermittel und ein Gaszufiihrungsmittel aufweist, wobei die Magnetron-Elektrode (32) eine flache Magentron-Front (20) mit peripheren und zentralen Magnetpolen entgegengesetzter Polarität und ein Mittel zur Erzeugung eines hochfrequenten, elektrischen Wechselfeldes aufweist, wobei das Positioniennittel ausgerüstet ist, um ein Substrat (25) mit einer zu behandelnden Oberfläche gegen die Magnetron-Front (20) gerichtet zu positionieren und wobei das Gaszuführungsmittel ausgerüstet ist für die Zuführung eines Prozessgases oder einer Prozessgasmischung zum Zwischenraum zwischen der Magnetron-Front (20) und dem zu behandelnden Substrat, **dadurch gekennzeichnet, dass** die Magnetron-Elektrode vom unausgeglichenen Typus ist und dass der Abstand zwischen der Magnetron-Front (20) und dem Positionierungsmittel an das durch die Magnetron-Elektrode erzeugte, magnetische Feld angepasst ist, derart, dass sich zwischen dunkleren Tunnels (11), die durch magnetische Feldlinien gebildet sind, die sich zwischen peripheren und zentralen Polen der Magnetron-Front erstrecken, und der zu behandelnden Oberfläche ein sichtbarer Plasmastreifen erstreckt, der eine minimale Breite hat aber gegen die zu behandelnde Oberfläche eine homogene Helligkeit.

2. Vorrichtung nach Anspruch 1, **dadurch gekennzeichnet, dass** der Abstand (A-C) zwischen der zu behandelnden Oberfläche und der Magnetron-Front (20) mindestens 2% grösser ist als die sichtbare Höhe (A-B) der Tunnels (11).

3. Vorrichtung nach einem der Ansprüche 1 oder 2, **dadurch gekennzeichnet, dass** der Abstand (A-C) zwischen der zu behandelnden Oberfläche und der Magnetron-Front (20) höchstens 20% grösser ist als die sichtbare Höhe (A-B) der Tunnels (11).

4. Vorrichtung nach einem der Ansprüche 1 bis 3, **dadurch gekennzeichnet, dass** die magnetische Stärke des zentralen Magnetpoles der Magnetron-Front (20) etwa halb so gross ist wie die magnetische Stärke der peripheren Pole.

5. Vorrichtung nach einem der Ansprüche 1 bis 4, **dadurch gekennzeichnet, dass** die Magnetron-Elektrode (32) ein Elektrodenelement (21) aufweist, das an eine Quelle (34) einer Wechselspannung angeschlossen ist.

6. Vorrichtung nach Anspruch 5, **dadurch gekennzeichnet, dass** das Positioniermittel und/oder das Substrat (25) elektrisch geerdet, ohne definiertes Referenzpotential oder negativ vorgespannt ist.

7. Vorrichtung nach einem der Ansprüche 1 bis 6, **dadurch gekennzeichnet, dass** das Positioniermittel eine rotierende Trommel (30) ist und dass eine Mehrzahl von Magnetron-Elektroden (32) mit rechteckigen Fronten um einen Teil des Trommelumfanges angeordnet ist, wobei die Front-Längen parallel zur Trommelachse ausgerichtet ist.

8. Vorrichtung nach Anspruch 7, **dadurch gekennzeichnet, dass** das Gaszuführungsmittel Gaszuführungsleitungen (33) aufweist, die sich zwischen den Magnetron-Fronten parallel zur Trommelachse erstrecken.

9. Vorrichtung nach einem der Ansprüche 7 oder 8, **dadurch gekennzeichnet, dass** jede Magnetron-Elektrode (32) der Mehrzahl von Magnetron-Elektroden (32) mit einer eigenen Spannungsquelle verbunden ist.

10. Verfahren zur Plasma-unterstützten Behandlung einer Oberfläche in einer Vakuumkammer, insbesondere zur Plasma-unterstützten, chemischen Abscheidung auf eine Oberfläche aus der Gasphase, unter Verwendung einer Vorrichtung nach einem der Ansprüche 1 bis 9, wobei mittels dem Positioniermittel ein Substrat (25) mit einer zu behandelnden Oberfläche gegen die Magnetron-Front (20) gerichtet positioniert wird, und über die Gaszuführungsmittel ein Prozessgases oder eine Prozessgasmischung zum Zwischenraum zwischen der Magnetron-Front (20) und dem zu behandelnden Substrat zugeführt wird, und über die Magnetron-Elektrode ein magnetische Feld sowie ein hochfrequentes, elektrisches Wechselfeldes erzeugt wird, **dadurch gekennzeichnet, dass** durch magnetische Feldlinien, die sich zwischen peripheren und zentralen Polen der Magnetron-Front erstrecken, dunklere Tunnels (11) ausgebildet werden, und zwischen den dunkleren Tunnels (11) und der zu behandelnden Oberfläche ein sichtbarer Plasmastreifen mit einer minimalen Breite ausgebildet wird, der gegen die zu behandelnde Oberfläche eine homogene Helligkeit aufweist.

11. Verfahren nach Anspruch 10, wobei das Prozessgases eine Organosilizium-Verbindung und Sauerstoff enthält und aus diesem Siliziumoxyd auf die zu behandelnde Oberfläche abgeschieden wird.

12. Verfahren nach Anspruch 11, wobei das Substrat ein bandförmiger Kunststofffilm ist, der zur Verbesserung der Barnereeigenschaften beschichtet wird.

## Claims

1. Device for carrying out a plasma enhanced process, in particular a plasma enhanced chemical vapour deposition process, the device comprising within a vacuum chamber a magnetron electrode (32), a positioning means and a gas supply means, wherein the magnetron electrode comprises a flat magnetron face (20) with peripheral and central magnetic poles of opposite polarities and a means for producing a high frequency alternating electric field, wherein the positioning means is equipped for positioning a substrate (25) with a surface to be treated facing the magnetron face (20) and the gas supply means is equipped for supplying a process gas or process gas mixture to the space between the magnetron face (20) and the surface to be treated, **characterized in that** the magnetron electrode (32) is of the unbalanced type and that a distance between the magnetron face (20) and the positioning means is adapted to the magnetic field created by the magnetron electrode (32) such that there is a visible plasma band running between darker tunnels (11) formed by magnetic field lines (10) extending between peripheral and central magnetic poles of the magnetron face (20) and the surface to be treated, the plasma band having a minimum width but having towards the surface to be treated a homogeneous brightness.

2. Device according to claim 1, **characterized in that** the distance (A-C) between the surface to be treated and the magnetron face (20) is at least 2% larger than the visible height (A-B) of the tunnels (11).

3. Device according to claim 1 or 2, **characterized in that** the distance (A-C) between the surface to be treated and the magnetron face (20) is at the most 20% larger than the visible height (A-B) of the tunnels (11).

4. Device according to one of claims 1 to 3, **characterized in that** the magnetic strength of the central magnetic pole of the magnetron face (20) is about half of the magnetic strength of the peripheral pole.

5. Device according to one of claims 1 to 4, **characterized in that** the magnetron electrode (32) comprises an electrode element (21) being connected to a source of an alternating voltage (34).

6. Device according to claim 5, **characterized in that** the positioning means and/or the substrate (25) are electrically grounded, electrically floating or negatively biased.

7. Device according to one of claims 1 to 6, **characterized in that** the positioning means is a rotating drum (30) and that a plurality of magnetron electrodes (32) having rectangular faces is arranged around a part of the circumference of the drum, wherein their front length is arranged parallel to the rotation axis of the drum.

8. Device according to claim 7, **characterized in that** the gas supply means comprises gas supply lines (33) extending parallel to the drum axis between the magnetron faces.

9. Device according to one of claims 7 or 8, **characterized in that** of the plurality of magnetrons (32) each magnetron (32) is connected to a separate power supply.

10. Method for the plasma enhanced treatment of a surface within a vacuum chamber , in particular a plasma enhanced chemical vapour deposition process upon a surface, by means of a device according to one of claims 1 to 9, wherein by means of a positioning means a substrate (25) with a surface to be treated is positioned facing the magnetron face (20), and by means of the gas supply means a process gas or process gas mixture is supplied to the space between the magnetron face (20) and the substrate to be treated, and by means of the magnetron electrode magnetic field as well as a high frequency alternating electric field is created, **characterized in that** darker tunnels (11) are formed by magnetic field lines (10) extending between peripheral and central magnetic poles of the magnetron face, and a visible plasma band of a minimum width is formed between the darker tunnels (11), the plasma band comprising a homogeneous brightness towards the surface to be treated.

11. Method according to claim 10, wherein the process gas contains an organosilicon compound and oxygen, and from it silicon oxide is deposited on the surface to be treated.

12. Method according to claim 11, wherein the substrate is a web of polymer film material being coated for improving its barrier properties.

## Revendications

1. Dispositif pour l'exécution d'un procédé soutenu par plasma, en particulier un dépôt chimique en phase gazeuse soutenu par plasma, ce dispositif présentant dans une chambre sous vide une électrode magnétron (32), un moyen de positionnement et un moyen d'amenée de gaz,
l'électrode magnétron (32) présentant un front magnétron plat (20) doté de pôles magnétiques périphériques et d'un pôle magnétique central de polarités opposées et un moyen de formation d'un champ électrique alternatif à haute fréquence,
le moyen de positionnement étant équipé pour positionner un substrat (25) avec la surface à traiter orientée vers le front magnétron (20) et le moyen d'amenée de gaz étant équipé pour amener un gaz de traitement ou un mélange de gaz de traitement dans l'espace intermédiaire situé entre le front magnétron (20) et le substrat à traiter,
**caractérisé en ce que**
l'électrode magnétron est du type non compensé et
**en ce que** la distance entre le front magnétron (20) et le moyen de positionnement est adaptée au champ magnétique produit par l'électrode magnétron, de telle sorte qu'un ruban visible de plasma qui a une largeur minimale mais dont la luminosité est homogène en direction de la surface à traiter s'étend entre la surface à traiter et des tunnels plus sombres (11) formés par les lignes de champs magnétiques et s'étendant entre le pôle périphérique et le pôle central du front magnétron.

2. Dispositif selon la revendication 1, **caractérisé en ce que** la distance (A-C) entre la surface à traiter et le front magnétron (20) est d'au moins 2 % plus grande que la hauteur visible (A-B) des tunnels (11).

3. Dispositif selon l'une des revendications 1 ou 2, **caractérisé en ce que** la distance (A-C) entre la surface à traiter et le front magnétron (20) est d'au plus 20 % plus grande que la hauteur visible (A-B) des tunnels (11).

4. Dispositif selon l'une des revendications 1 à 3, **caractérisé en ce que** l'intensité magnétique du pôle magnétique central du front magnétron (20) représente environ la moitié de l'intensité magnétique des pôles périphériques.

5. Dispositif selon l'une des revendications 1 à 4, **caractérisé en ce que** électrode magnétron (32) présente un élément d'électrode (21) raccordé à une source (34) de tension alternative.

6. Dispositif selon la revendication 5, **caractérisé en ce que** le moyen de positionnement et/ou le substrat (25) sont raccordés électriquement à la masse, ne présentent pas de potentiel de référence défini ou sont placés à un potentiel négatif.

7. Dispositif selon l'une des revendications 1 à 6, **caractérisé en ce que** le moyen de positionnement est un tambour rotatif (30) et **en ce que** plusieurs électrodes magnétron (32) à front rectangulaire sont disposées autour d'une partie de la périphérie du tambour, la longueur des fronts étant orientée parallèlement à l'axe du tambour.

8. Dispositif selon la revendication 7, **caractérisé en ce que** le moyen d'amenée de gaz présente des conduits (33) d'amenée de gaz qui s'étendent entre les fronts magnétron et parallèlement à l'axe du tambour.

9. Dispositif selon l'une des revendications 7 ou 8, **caractérisé en ce que** chaque électrode magnétron (32) des différentes électrodes magnétron (32) est raccordée à une source de tension propre.

10. Procédé de traitement soutenu par plasma d'une surface dans une chambre sous vide, en particulier de dépôt chimique en phase gazeuse, soutenu par plasma, sur une surface, par recours à un dispositif selon l'une des revendications 1 à 9,
un substrat (25) dont la surface à traiter est orientée vers le front magnétron (20) étant positionnée à l'aide du moyen de positionnement,
un gaz de traitement ou un mélange de gaz de traitement étant apportés par le moyen d'amenée de gaz dans l'espace intermédiaire situé entre le front magnétron (20) et le substrat à traiter et un champ magnétique ainsi qu'un champ électrique alternatif à haute fréquence étant formés par l'électrode magnétron, **caractérisé en ce que**
des tunnels plus sombres (11) sont formés par les lignes de champ magnétique qui s'étendent entre les pôles périphériques et le pôle central du front magnétron, et
**en ce qu'**un ruban visible de plasma de largeur minimale et qui présente une luminosité homogène en direction de la surface à traiter est formé entre les tunnels plus sombres (11) et la surface à traiter.

11. Procédé selon la revendication 10, dans lequel le gaz de traitement contient composé organique du silicium et de l'oxygène et en ce qu'un oxyde de silicium est déposé sur la surface à traiter à partir de ce composé.

12. Procédé selon la revendication 11, dans lequel le substrat est un film de matière synthétique en forme de bande qui est revêtu en vue d'améliorer ses propriétés de barrière.
